(19) Europäisches Patentamt
European Patent Office
Office européen des brevets

(11) EP 0 594 994 B1

(12) **EUROPEAN PATENT SPECIFICATION**

(45) Date of publication and mention
of the grant of the patent:
**10.03.1999 Bulletin 1999/10**

(51) Int Cl.[6]: **H01L 29/16**

(21) Application number: **93114590.8**

(22) Date of filing: **10.09.1993**

(54) **Semiconductor diamond and process for producing the same**

Diamant-Halbleiter und Verfahren zur Herstellung

Diamant semi-conducteur et procédé pour l'obtenir

(84) Designated Contracting States:
**DE FR GB NL**

(30) Priority: **14.09.1992 JP 244723/92**
**30.08.1993 JP 214192/93**
**31.08.1993 JP 216286/93**

(43) Date of publication of application:
**04.05.1994 Bulletin 1994/18**

(73) Proprietor: **SUMITOMO ELECTRIC INDUSTRIES, LIMITED**
**Osaka 541 (JP)**

(72) Inventors:
- **Nishibayashi, Yoshiki,**
  **c/o Itami Works of Sumitomo**
  **Itami-shi, Hyogo (JP)**
- **Tomikawa, Tadashi,**
  **c/o Itami Works of Sumitomo**
  **Itami-shi, Hyogo (JP)**
- **Sikata, Shinichi, c/o Itami Works of Sumitomo**
  **Itami-shi, Hyogo (JP)**

(74) Representative: **Grosse, Wolfgang, Dipl.-Ing. et al**
**Patentanwälte**
**Herrmann-Trentepohl**
**Grosse - Bockhorni & Partner,**
**Forstenrieder Allee 59**
**81476 München (DE)**

(56) References cited:
- PATENT ABSTRACTS OF JAPAN vol. 17, no. 1 (C-1014) 5 January 1993 & JP-A-04 238 895 (SUMITOMO ELECTRIC IND LTD) 26 August 1992
- JAPANESE JOURNAL OF APPLIED PHYSICS, vol.29, no.12, December 1990, TOKYO JP pages L2163 - L2164 H. SHIOMI 'HIGH-VOLTAGE SCHOTTKY DIODES ON BORON-DOPED DIAMOND EPITAXIAL FILMS'
- SEMICONDUCTOR SCIENCE AND TECHNOLOGY, vol.6, no.6, June 1991, LONDON GB M.I. EREMETS 'SEMICONDUCTING DIAMOND'

**Description**

BACKGROUND OF THE INVENTION

Field of the Invention

The present invention relates to semiconductor diamond which may suitably be used in various semiconductor devices, such as diodes and transistors.

Related Background Art

Diamond is noted as a material applicable to a semiconductor device which is stably operative under severe circumstances, e.g., at high temperature, under radiation, etc., or is durably operative at high output.

A reason for operativeness of diamond at high temperature is its band gap which is as large as 5.5 eV. In other words, intrinsic range, i.e., a temperature range where carriers of diamond semiconductor cannot be controlled is absent below 1400 °C.

However, up to the present, n-type semiconductor diamond of low resistance has not been obtained. This has been a very serious barrier to the development and application of diamond devices.

The document JP-A-4-238 895 discloses a single crystal or polycrystal diamond film which has been grown on diamond or other substrates and is doped with 1 to 1000 ppm nitrogen and phosphorus or sulfur in an amount of 0.1 to 50 % based on the nitrogen content.

However, this citation does not teach or suggest semiconductor diamond nor a production process therefor which has the specific relationship of $100CB \geq CN > CB$, but also have the specific carrier density or half-value width of rocking curve of the present invention.

SUMMARY OF THE INVENTION

An object of the present invention is to provide n-type semiconductor diamond having a low resistance, and a process for producing the same.

Another object of the present invention is to provide semiconductor diamond doped with nitrogen atoms and having a low resistance, and a process for producing the same. It is expected that, as in the case of silicon (Si), diamond becomes p-type semiconductor when doped with a Group III element, and becomes n-type semiconductor when doped with a Group V element. However, carbon atoms constituting diamond have such a small atomic radius and a high density that all impurities cannot be added to diamond, but elements having a relatively small atomic radius, such as boron, nitrogen and phosphorus, can be added to diamond.

However, when diamond is doped with nitrogen atoms as a donor, the resultant donor level is very deep from conduction band (about 1 eV to 2 eV). Such a level is very low even in comparison with the acceptor level of boron (0.37 eV). Accordingly, when diamond is simply doped with nitrogen atoms as a donor, n-type semiconductor of low resistance cannot be obtained.

As a result of earnest study, the present inventors have found that when the nitrogen concentration in diamond is increased to a very high value, carriers in the diamond can be transferred between nitrogen levels, and low-resistance conductivity can be obtained even at room temperature.

The present invention is based on the above discovery.

As described above, diamond semiconductor of low resistance may be provided by increasing the nitrogen atom concentration to a very high value. In consideration of a fact that pure Si with a band gap of 1.1 eV has a very high resistance, the concept of the present invention that semiconductor of low resistance is provided by using a dopant (nitrogen atoms) having an impurity level as low as 1 - 2 eV is quite different from the conventional concept.

As a result of studies, the present inventors have found that doping diamond not only with nitrogen atoms, but also with boron atoms in a specific concentration range is very effective to solve the above-mentioned problem.

Therefore, according to the present invention, there is provided n-type diamond semiconductor comprising diamond doped with nitrogen atoms and boron atoms, which has a concentration of nitrogen atoms (CN) and a concentration of boron atoms (CB) satisfying a relationship of $100CB \geq CN > CB$, and has a carrier density of $1 \times 10^{16}$ cm$^{-3}$ or more.

According to the present inventors' findings, it may be considered that low level of nitrogen provided in a case where diamond is doped with nitrogen atoms in a low concentration, is based on local distortion of the diamond crystal structure due to the low-concentration nitrogen atoms as a dopant. Further, according to the present inventors' findings, it may be considered that the lattice distortion caused by the doping of the diamond with the nitrogen atoms is reduced by further doping the diamond with boron atoms, whereby the nitrogen level is raised and conductivity of low resistance is consequently obtained even at room temperature.

According to the present invention, there is further provided a process for producing semiconductor diamond by vapor deposition (or vapor-phase synthesis), comprising doping diamond with nitrogen atoms so as to provide a nitrogen atom concentration of $1 \times 10^{19} cm^{-3}$ or more, by use of a reactant gas comprising a nitrogen atom-containing gas.

The present invention further provides a process for producing semiconductor diamond by vapor deposition, comprising doping diamond with nitrogen atoms and boron atoms so as to provide a nitrogen atom concentration (CN) and a boron atom concentration (CB) satisfying a relationship of $100CB \geq CN > CB$, and has a carrier density of $1 \times 10^{16} cm^{-3}$ or more, by use of a reactant gas comprising a nitrogen atom-containing gas and a boron atom-containing gas.

The present invention further provides semiconductor diamond comprising diamond which is doped with nitrogen atoms in a concentration of $1 \times 10^{19} cm^{-3}$ or more.

The present invention further provides n-type semiconductor diamond comprising diamond which is doped with nitrogen atoms and boron atoms respectively in a nitrogen atom concentration (CN) and a boron atom concentration (CB) satisfying a relationship of $100CB \geq CN > CB$, and has a carrier density of $1 \times 10^{16} cm^{-3}$ or more, and has a half-value width (or half-width) of rocking curve of 40 seconds or less based on a double-crystal X-ray diffraction method.

Since diamond has a wide band gap of 5.5 eV, a temperature range corresponding to the intrinsic region is absent below 1400 °C at which diamond is thermally stable. In addition, diamond is chemically very stable. Further, diamond has characteristics inclusive of a thermal conductivity of 20 (W/cm·K), which is 10 times or more that of Si, good thermal radiation, large carrier mobility (electron mobility: 2000 ($cm^2$/V·sec), hole mobility: 2100 ($cm^2$/V·sec) at 300 K), small dielectric constant (K=5.5), high breakdown electric field (E=$5 \times 10^6$V/cm), etc. Based on these characteristics, a device for high frequency and/or large power can be formed by use of diamond.

In the present invention, in order to obtain n-type semiconductor which is essential to a diamond device, a large amount of nitrogen atoms are added to diamond as a dopant, and a predetermined amount of boron atoms are added to diamond as a dopant together with a predetermined amount of nitrogen atoms.

The present invention will become more fully understood from the detailed description given hereinbelow and the accompanying drawings which are given by way of illustration only, and thus are not to be considered as limiting the present invention.

## BRIEF DESCRIPTION OF THE DRAWINGS

Fig. 1 is a graph of temperature dependency of a carrier density in a diamond film doped with nitrogen obtained in Example 1.

Fig. 2 is a graph of temperature dependency of a carrier density in a diamond film doped with nitrogen and boron obtained in Example 2.

## DETAILED DESCRIPTION OF PREFERRED EMBODIMENTS

Hereinbelow, preferred embodiments of the present invention will be described in more detail.

(Semiconductor Diamond)

The semiconductor diamond to which the present invention is applicable is not particularly restricted. For example, the diamond usable in the present invention may comprise artificial (high-pressure synthesis) bulk single crystal, or thin polycrystal film or thin single crystal film (epitaxial film) based on vapor deposition (or vapor-phase synthesis). Advantageous effects of the present invention may be provided regardless of the above kinds of diamond.

The semiconductor diamond according to the present invention is n-type in view of the application thereof to a semiconductor device.

The semiconductor diamond according to the present invention may preferably have a resistivity of $1 \times 10^5 \Omega \cdot cm$ or less, more preferably 1000 $\Omega \cdot cm$ or less (particularly preferably 100 $\Omega \cdot cm$ or less).

In the measurement of the above resistivity, for example, the following measuring conditions may preferably be used.

Measuring method: Four probe method

Measuring condition: Voltage (1-100 V) is measured under application of a constant current (10 µA - 1 mA).

(Diamond Forming Method)

In a case where a diamond film is formed by vapor deposition, for example, various methods as described below may be used.

1) A method wherein electric discharge is conducted by use of a DC or AC electric field so as to activate a raw material gas (or reactant gas).
2) A method wherein a thermoelectron emitting material(or (or thermionic emission material) is heated to activate a raw material gas.
3) A method wherein a surface on which diamond is to be grown is bombarded with ions.
4) A method wherein a raw material gas is excited by light such as laser beam and UV rays.
5) A method wherein a raw material gas is burned.

All of these methods may be used in the present invention. Advantageous effects of the present invention may be provided regardless of the above kinds of diamond-forming method.

In the present invention, it is preferred to use a CVD (chemical vapor deposition) process in order to dope diamond with nitrogen atoms and/or boron atoms, since the amount of a dopant to be added to the diamond may easily be regulated in the CVD process.

(CVD Process)

The reactant gas (or raw material gas) to be used in the CVD is not particularly restricted, as long as diamond can be deposited or grown on a substrate. More specifically, for example, it is preferred to use a mixture gas comprising $CH_4$ diluted with $H_2$, a mixture gas comprising ethyl alcohol or acetone diluted with $H_2$, a mixture gas comprising CO diluted with $H_2$, etc., as the reactant gas.

In the case of formation of diamond doped with nitrogen atoms, it is preferred that a nitrogen atom-containing gas is added to the above reactant gas in an amount corresponding to a desired concentration of nitrogen atoms in the semiconductor diamond to be formed. As the nitrogen atom-containing gas, for example, it is preferred to use $N_2$, $N_2O$, $NO_2$, $NH_3$, etc.

In the present invention, in the case of formation of diamond doped with nitrogen atoms and boron atoms, it is preferred that a nitrogen atom-containing gas and a boron atom-containing gas are added to the above reactant gas in amounts respectively corresponding to a desired concentration of nitrogen atoms and a desired concentration of boron atoms in the semiconductor diamond to be formed. As the boron atom-containing gas, for example, it is preferred to use $B_2H_6$, $B_2O_3$, $B_2(CH_3)_3$, $B_2(OCH_3)_3$, etc.

(High Pressure Synthesis)

In a case where high-pressure synthesis is used for diamond formation, there may be used a method wherein a raw material, a solvent and/or a nitrogen-containing raw material are loaded into a high-pressure synthesis vessel to form nitrogen-containing diamond by the high pressure synthesis, a method wherein a raw material containing nitrogen and boron is loaded into a high-pressure synthesis vessel to form diamond containing nitrogen and boron by the high pressure synthesis, etc. Advantageous effects of the present invention may be provided regardless of the above kinds of diamond-forming method.

(Ion Implantation)

In the present invention, a method of adding nitrogen and boron by ion implantation may also be used. In such a case, in general, it is not easy to obtain the above-described advantageous effects in the case of a sample immediately after the sample is subjected to the ion implantation. However, it is possible to obtain the above-described advantageous effects, e.g., by controlling a condition for the ion implantation (ion implantation at a high temperature, etc.), or a condition for processing or treatment for restoration of crystallinity (hydrogen plasma processing, etc.).

(Concentration of Nitrogen Atoms)

The concentration of nitrogen atoms (dopant) added to the semiconductor diamond according to the present invention may preferably be $1 \times 10^{19}$ $cm^{-3}$ or more. In a case where diamond is doped with nitrogen atoms together with another dopant, the nitrogen atom concentration may preferably be $1 \times 10^{17}$ $cm^{-3}$ or more in view of semiconductor characteristics.

The above concentration of nitrogen atoms can be measured, e.g., by secondary ion mass spectrometry (SIMS). In the SIMS measurement, for example, the following conditions may suitably be used.

|  | (N analysis) | (B analysis) |
|---|---|---|
| Primary ion | $Cs^+$ | $O_2^+$ |
| Acceleration voltage | 10 kV | 15 kV |
| Current | 580 nA | 2000 nA |
| Raster size | 250 μm square | 250 μm square |
| Analysis area | diameter 62 μmΦ | 62 μmΦ |

(Concentration of Boron Atoms)

According to the present invention, the concentration of the nitrogen atom dopant (CN), and the concentration of the boron atom dopant (CB) satisfy the relationship of 100CB≥CN>CB, more preferably 10CB≥CN>CB, in view of a balance between characteristics of the n-type semiconductor and conductivity thereof. In such a case, the concentration of the nitrogen atoms may preferably be $10^{17}$ cm$^{-3}$ or more in view of conductivity.

The above concentration of the boron atoms can be measured, e.g., by SIMS as described above. In this SIMS measurement, the measuring conditions (B analysis) as described above may suitably be used.

(Carrier Density)

In the semiconductor diamond according to the present invention, the carrier density (or carrier concentration) is $1 \times 10^{16}$ cm$^{-3}$ or more, in view of conductivity.

The above carrier density can be determined on the basis of measurement of a Hall coefficient (See, e.g., Masaharu Aoki and Yasuo Nannichi (translation) "Physics of Semiconductor", p.46, 1969, Sangyo Tosho, Tokyo).

In the above measurement of the Hall coefficient, for example, the following measuring conditions may suitably be used.

| Magnetic field to be applied | 5000 Gauss |
|---|---|
| Sample current | 0.01 - 1 mA |

(Current values in this range do not substantially influence the measured value of carrier density.)

(Crystallinity)

Crystallinity of the semiconductor diamond according to the present invention may be evaluated by a double-crystal method of X-ray diffraction. More specifically, in the semiconductor diamond according to the present invention, the half-value width of a rocking curve given by the double-crystal method of X-ray diffraction may preferably be 40 seconds or less, more preferably 20 seconds or less (particularly preferably 10 seconds or less).

In the "double-crystal method of X-ray diffraction" used herein, in front of a second crystal $C_2$ which is a specimen in a single-crystal method, another crystal $C_1$ (a first crystal which functions as a monochromator and collimator) is positioned so as to enhance the parallelism and monochromaticity of the X-ray diffraction. In the present invention, the first and second crystals $C_1$ and $C_2$ are so arranged that reflecting directions of an X-ray beam on the first and second crystals $C_1$ and $C_2$ are opposite from each other (minus arrangement), and the order (m) of the reflection on the first crystal $C_1$, and the order (n) of the reflection on the second crystal $C_2$ are the same (minus parallel arrangement). The "minus parallel arrangement" may provide very high resolving power with respect to angle.

The above "rocking curve" means an intensity distribution curve of diffracted beam in a case where a monochromatic X-ray is applied to the crystal, and the crystal is rotated in the neighborhood of a direction satisfying the Bragg condition.

The half-value width $(\Delta W_D)$ of a rocking curve measured by the above-described double-crystal method is approximately given by the following formula:
(For minus arrangement)

$$\left(\Delta W_D\right)^2 = \left(\Delta W_1\right)^2 + \left(\Delta W_2\right)^2 + \delta^2$$

where $\Delta W_1$ and $\Delta W_2$ respectively represent widths of Darwin plateaux of the first and second crystals, and

$$\delta = (\Delta\lambda/\lambda) \, (\tan\theta_{B1} - \tan\theta_{B2}).$$

In the above formula, $\theta_{B1}$ and $\theta_{B2}$ respectively represent Bragg angles of the respective crystals, $\lambda$ represents the wavelength of the X-ray, and $\Delta\lambda$ is a half-value width of a characteristic X-ray (e.g., $5.8 \times 10^{-4}$ angstrom for CuK$\alpha_1$ ray). For more details of the above-mentioned "Double Crystal Method of X-ray Diffraction", Nishibayashi et al., "Transactions of the 53rd Autumn Applied Physics Conference", p408, 1992 (Evaluation of Diamond Single Crystal by Double-crystal Method)" may be referred to.

In the measurement of the above-described rocking curve, the following conditions, for example, may preferably be used.

| X-ray tube | 35 kV, 10 mA |
|---|---|
| Diamond | (004), parallel arrangement |

The present invention will be described in further detail with reference to a specific embodiment.

Example 1 (not forming part of the present invention)

A non-doped diamond layer was formed on a (100) plane of an artificial single crystal diamond substrate (Ib type) synthesized by high-pressure and high-temperature synthesis method, and on an Si substrate, respectively, by microwave plasma CVD. On the thus formed non-doped diamond layer, a nitrogen-doped diamond layer was formed, respectively, whereby two kinds of samples were prepared. The respective layers were formed typically under the following conditions.

| (Non-doped layer) | |
|---|---|
| $H_2$ flow rate | 100 SCCM |
| $CH_4$ flow rate | 0.5 - 6 SCCM |
| Pressure | 40 Torr |
| Power | 300 W |
| Substrate temperature | about 800 °C |
| Film thickness | about 2 μm |

| (Nitrogen-doped layer) | |
|---|---|
| $H_2$ flow rate | 100 SCCM |
| $CH_4$ flow rate | 0.5 - 6 SCCM |
| $NH_3$ flow rate | 5 SCCM |
| Pressure | 40 Torr |
| Power | 300 W |
| Substrate temperature | about 800 °C |
| Film thickness | about 1 μm |

On the other hand, as comparative samples, two kinds of samples only including a non-doped diamond layer (film thickness: 2 μm) without a nitrogen-doped layer were also prepared. Conductivities of the films of the thus formed comparative samples could not be determined, because of their very high resistivities. The resistivities were above $10^{10}$ Ω·cm.

When the Hall effect of the film (nitrogen-doped layer) of the nitrogen-doped samples prepared above was measured, it was found that the type of conduction of the film was n-type. The nitrogen atom content of each nitrogen-doped layer was measured by SIMS, and the resistivity of each nitrogen-doped layer was measured by a four probe method.

The following Table 1 shows the above measurement results (Table 1 shows a case where the nitrogen-doped layer was formed on the diamond substrate).

| METHANE CONCENTRATION $CH_4/H_2$ | SUBSTRATE TEMP. | AMMONIA FLOW RATE $NH_3/CH_4$ | NITROGEN CONTENT $cm^{-3}$ | RESISTIVITY $\Omega \cdot cm$ |
|---|---|---|---|---|
| 0.5% | 850°C | 0.001 | $2 \times 10^{18}$ | $2 \times 10^6$ |
| | | 0.005 | $1 \times 10^{19}$ | 2000 |
| | | 0.01 | $2 \times 10^{19}$ | 200 |
| | | 0.1 | $2 \times 10^{20}$ | 30 |
| | | 1 | $2 \times 10^{21}$ | 5 |
| | | 10 | $5 \times 10^{21}$ | 2 |
| 6% | 850°C | 0.001 | $7 \times 10^{19}$ | $6 \times 10^5$ |
| | | 0.01 | $8 \times 10^{19}$ | 200 |
| | | 0.1 | $9 \times 10^{20}$ | 20 |
| | | 1 | $5 \times 10^{21}$ | 4 |
| | | 10 | $1 \times 10^{22}$ | 3 |

As shown in the above Table 1, n-type semiconductor diamonds of low resistivity were formed at nitrogen atom concentrations of $1 \times 10^{19}$ $cm^{-3}$ or more in the nitrogen-doped film.

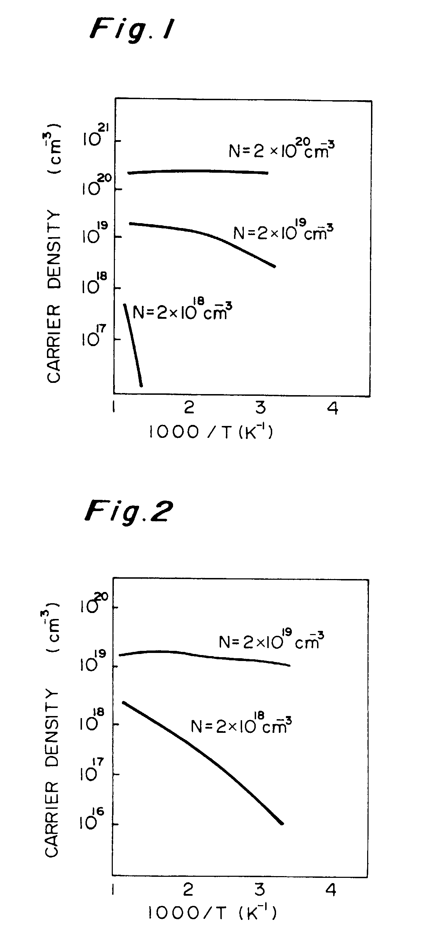

In addition, when the temperature dependency of a carrier density in the nitrogen-doped film was investigated, the results as shown in Fig. 1 were obtained (Fig.1 shows a case where the nitrogen-doped films was formed on the diamond substrate).

As shown in Fig. 1, it was found that the carrier concentration was not substantially affected by the temperature when the nitrogen atom concentration (N) was not less than a certain value. It was also found that, on the basis of the above measurement results, a resistivity of $1 \times 10^5$ $\Omega \cdot cm$ or less could be obtained at carrier concentrations of $1 \times 10^{16}$ $cm^{-3}$ or more.

Nitrogen-doped films were formed in the same manner as described above, except that the film forming condition for the nitrogen-doped film was changed. The measurement results of the thus formed nitrogen-doped films are shown in the following Table 2 (Table 2 shows a case where the nitrogen-doped film was formed on the diamond substrate).

| METHANE CONCENTRATION $CH_4/H_2$ | SUBSTRATE TEMP. | AMMONIA FLOW RATE $NH_3/CH_4$ | NITROGEN CONC. $cm^{-3}$ | RESISTIVITY $\Omega \cdot cm$ |
|---|---|---|---|---|
| 0.5% | 950°C | 0.1 | $1 \times 10^{20}$ | 50 |
| | 850°C | 0.1 | $2 \times 10^{20}$ | 30 |
| | 750°C | 0.1 | $4 \times 10^{20}$ | 30 |
| 1% | 850°C | 0.1 | $3 \times 10^{20}$ | 50 |
| 2% | 850°C | 0.1 | $4 \times 10^{20}$ | 25 |
| 4% | 850°C | 0.1 | $8 \times 10^{20}$ | 20 |
| 6% | 950°C | 0.1 | $8 \times 10^{20}$ | 30 |
| | 850°C | 0.1 | $8 \times 10^{20}$ | 20 |
| | 750°C | 0.1 | $9 \times 10^{20}$ | 20 |

In a case where nitrogen-doped films were formed on the Si substrates, there were obtained the same tendencies as in the results of Tables 1 and 2, and Fig. 1 (the case where the nitrogen-doped films were formed on the single crystal diamond substrates). In comparison with the case where the nitrogen-doped films were formed on the Si substrates, better nitrogen-doped films of lower resistivities were obtained in the case where the nitrogen-doped films were formed on the single crystal diamond substrates.

Embodiment of the present invention

A non-doped diamond layer was formed on a (100) plane of an artificial single crystal diamond substrate (Ib type), and on an Si substrate, respectively, by microwave plasma CVD. On the thus formed non-doped diamond layer, a diamond layer doped with nitrogen and boron was formed,
respectively, whereby two kinds of samples were prepared. The respective layers were formed typically under the following conditions.

| (Non-doped layer) | |
|---|---|
| $H_2$ flow rate | 100 SCCM |
| $CH_4$ flow rate | 0.5 - 6 SCCM |
| Pressure | 40 Torr |
| Power | 300 W |
| Substrate temperature | about 850 °C |
| Film thickness | about 2 $\mu$m |
| (Nitrogen- and boron-doped layer) | |
| $H_2$ flow rate | 100 SCCM |
| $CH_4$ flow rate | 0.5 - 6 SCCM |
| $B_2H_6$ (diluted with hydrogen, concentration: 100 ppm) | |
| flow rate | 1 SCCM |
| $NH_3$ flow rate | 0.5 SCCM |
| Pressure | 40 Torr |
| Power | 300 W |
| Substrate temperature | about 850 °C |
| Film thickness | about 1 $\mu$m |

On the other hand, as comparative samples, two kinds of samples only including a non-doped diamond layer (film thickness: 2 $\mu$m) without a nitrogen- and boron-doped layer were also prepared. Resistivities of the films of the thus formed comparative samples were above $10^{10}$ $\Omega$·cm, similarly as in Example 1.

When the Hall effect of the film (nitrogen- and boron-doped layer) of the thus formed nitrogen- and boron-doped samples was measured, it was found that the type of conduction of the film was n-type. The nitrogen atom content and boron atom content of each of the nitrogen- and boron-doped layers were measured by SIMS, and the resistivity of each nitrogen- and boron-doped layer was measured by a four probe method. The following Table 3 shows the above measurement results, i.e., nitrogen content, boron content, and resistivity of the film (Table 3 shows a case where the nitrogen and boron-doped layer was formed on the diamond substrate).

| METHANE CONC. $CH_4/H_2$ | SUBSTRATE TEMP. | AMMONIA AMOUNT $NH_3/CH_4$ | DIBORANE AMOUNT $B_2H_6/CH_4$ | NITROGEN CONTENT $cm^{-3}$ | BORON CONTENT $cm^{-3}$ | RESISTIVITY $\Omega \cdot cm$ |
|---|---|---|---|---|---|---|
| 0.5% | 850°C | 0.01% | 0.5ppm | $1\times10^{17}$ | $5\times10^{14}$ | $>5\times10^6$ |
| | | 0.01% | 2ppm | $1\times10^{17}$ | $2\times10^{15}$ | 20000 |
| | | 0.01% | 20ppm | $1\times10^{17}$ | $2\times10^{16}$ | 2000 |
| | | 0.01% | 200ppm | $1\times10^{17}$ | $2\times10^{17}$ | p-type |
| | | 0.1% | 10ppm | $2\times10^{18}$ | $1\times10^{16}$ | $>1\times10^6$ |
| | | 0.1% | 200ppm | $2\times10^{18}$ | $2\times10^{16}$ | 3000 |
| | | 0.1% | 400ppm | $2\times10^{18}$ | $4\times10^{16}$ | 600 |
| | | 0.1% | 400ppm | $2\times10^{18}$ | $4\times10^{17}$ | 300 |
| | | 0.1% | 4000ppm | $2\times10^{18}$ | $4\times10^{18}$ | p-type |
| | | 1% | 2000ppm | $2\times10^{19}$ | $2\times10^{18}$ | 30 |
| | | 5% | 10000ppm | $1\times10^{20}$ | $1\times10^{19}$ | 5 |
| 6% | 850°C | 0.01% | 2ppm | $1\times10^{18}$ | $2\times10^{17}$ | 300 |
| | | 0.1% | 20ppm | $1\times10^{19}$ | $2\times10^{18}$ | 20 |
| | | 1% | 200ppm | $1\times10^{20}$ | $2\times10^{19}$ | 3 |
| | | 10% | 2000ppm | $1\times10^{21}$ | $2\times10^{20}$ | 0.3 |

As shown in the above Table 3, n-type semiconductor diamonds of low resistivity were formed at nitrogen atom concentrations and boron atom concentrations satisfying a relationship of $100CB \geq CN > CB$ in the nitrogen- and boron-doped film.

In addition, when the temperature dependency of a carrier density in the nitrogen- and boron-doped film was investigated, the results as shown in Fig. 2 were obtained (Fig.2 shows a case where the nitrogen- and boron-doped film was formed on the diamond substrate). As shown in Fig. 2, it was found that the activation energy was reduced to a very small value in comparison with a film containing no boron atom, and a low resistivity was obtained even at room temperature.

Nitrogen- and boron-doped films were formed in the same manner as described above, except that the film forming condition for the nitrogen- and boron-doped film was changed. The measurement results of the thus formed nitrogen-and boron-doped films are shown in the following Table 4 (Table 4 shows a case where the nitrogen- and boron-doped film was formed on the diamond substrate).

| METHANE CONC. $CH_4/H_2$ | SUBSTRATE TEMP. | AMMONIA FLOW RATE $NH_3/CH_4$ | DIBORANE FLOW RATE $B_2H_6/CH_4$ | NITROGEN CONTENT $cm^{-3}$ | RESISTIVITY $\Omega \cdot cm$ |
|---|---|---|---|---|---|
| 0.5% | 950°C | 1% | 2000ppm | $1\times10^{19}$ | 40 |
| | 850°C | 1% | 2000ppm | $2\times10^{19}$ | 30 |
| | 750°C | 1% | 2000ppm | $4\times10^{19}$ | 30 |
| 1% | 850°C | 1% | 2000ppm | $2\times10^{19}$ | 30 |
| 2% | 850°C | 1% | 1000ppm | $4\times10^{19}$ | 20 |
| 4% | 850°C | 1% | 200ppm | $1\times10^{20}$ | 3 |
| 6% | 850°C | 1% | 200ppm | $1\times10^{20}$ | 3 |

In a case where nitrogen- and boron-doped films were formed on the Si substrates, there were obtained the same tendencies as in the results of Tables 3 and 4, and Fig. 2 (the case where the nitrogen- and boron-doped films were formed on the single crystal diamond substrates). In comparison with the case where the nitrogen- and boron-doped films were formed on the Si substrates, nitrogen- and boron-doped films of lower resistivities were obtained in the case where the nitrogen and boron-doped films were formed on the single crystal diamond substrates.

Example 3

Nitrogen-doped films, and nitrogen- and boron-doped films were respectively formed in the same manner as described in Examples 1 and 2, except that the films were formed on a (100) plane of natural IIa and Ia diamonds, respectively, as substrates. The measurement results of the thus formed nitrogen-doped films, and nitrogen- and boron-doped films were substantially the same as those obtained in Examples 1 and 2.

As described hereinabove, according to the present invention, there is provided semiconductor diamond comprising diamond doped with nitrogen atoms in a predetermined concentration (preferably, concentration of $1 \times 10^{19} cm^{-3}$ or more).

In the semiconductor diamond according to the present invention, the carrier density has substantially no temperature dependency in a temperature range of from room temperature to about 600 °C. In addition, the semiconductor diamond according to the present invention may be formed while the carrier density therein is controlled. The semiconductor diamond according to the present invention which has a low resistance even at room temperature, is applicable to various semiconductor devices, e.g., semiconductor devices which can exhibit stable diode characteristics or transistor characteristics, etc., in operation thereof in a temperature range of from room temperature to a high temperature, under radiation and/or at high outputs.

From the invention thus described, it will be obvious that the invention may be varied in many ways.

## Claims

1. Semiconductor diamond comprising diamond doped with nitrogen atoms and boron atoms respectively in a nitrogen atom concentration (CN) and a boron atom concentration (CB) satisfying a relationship of $100CB \geq CN > CB$, and has a carrier density of $1 \times 10^{16} cm^{-3}$ or more.

2. Semiconductor diamond according to claim 1, which comprises diamond doped with nitrogen atoms in a concentration of $1 \times 10^{19} cm^{-3}$ or more.

3. Semiconductor diamond according to claim 1, which comprises diamond doped with nitrogen atoms in a concentration of $1 \times 10^{19} cm^{-3}$ or more, and has a half-value width of rocking curve of 40 seconds or less based on a double-crystal X-ray diffraction method.

4. A process for producing semiconductor diamond by vapor deposition, comprising doping diamond with nitrogen atoms and boron atoms so as to provide a nitrogen atom concentration (CN) and a boron atom concentration (CB) satisfying a relationship of $100CB \geq CN > CB$, and a carrier density of $1 \times 10^{16} cm^{-3}$ or more, by use of a reactant gas comprising a nitrogen atom-containing gas and a boron atom-containing gas so as to provide a predetermined nitrogen atom concentration.

5. A process for producing semiconductor diamond according to claim 3, which comprises doping diamond with nitrogen atoms so as to provide a nitrogen atom concentration of $1 \times 10^{19} cm^{-3}$ or more, by use of a reactant gas comprising a nitrogen atom-containing gas.

6. Semiconductor diamond according to claim 1, which has a half-value width of rocking curve of 40 seconds or less based on a double-crystal X-ray diffraction method.

## Patentansprüche

1. Halbleiter-Diamant, umfassend Diamant, welcher mit Stickstoffatomen bzw. Boratomen in einer Stickstoffatomkonzentration (CN) und einer Boratomkonzentration (CB) dotiert ist, welche eine Beziehung von $100\ CB \geq CN > CB$ genügen und welcher eine Trägerdichte von $1 \times 10^{16} cm^{-3}$ oder mehr aufweist.

2. Halbleiterdiamant gemäß Anspruch 1, welcher Diamant umfaßt, der mit Stickstoffatomen in einer Konzentration von $1 \times 10^{19} cm^{-3}$ oder mehr dotiert ist.

**3.** Halbleiterdiamant gemäß Anspruch 1, welcher Diamant umfaßt, der mit Stickstoffatomen in einer Konzentration von $1 \times 10^{19}$ cm$^{-3}$ oder mehr dotiert ist und welcher eine Halbwertsbreite einer Rocking-Kurve von 40 Sekunden oder weniger aufweist, und zwar auf der Grundlage eines Doppelkristall-Röntgenbeugungsverfahrens.

**4.** Verfahren zum Herstellen von Halbleiterdiamant durch Abscheidung aus der Gasphase, umfassend: Dotieren von Diamant mit Stickstoffatomen und Boratomen, um eine Stickstoffatomkonzentration (CN) und eine Boratomkonzentration (CB) vorzusehen, welche eine Beziehung von $100CB \geq CN > CB$ erfüllen, und eine Trägerdichte von $1 \times 10^{16}$ cm$^{-3}$ oder mehr vorzusehen, und zwar durch Verwendung eines Reaktionsgases, welches ein stickstoffatomenthaltendes Gas und ein boratomenthaltendes Gas umfaßt, um eine vorbestimmte Stickstoffatomkonzentration vorzusehen.

**5.** Verfahren zum Herstellen von Halbleiterdiamant nach Anspruch 3, welches Dotieren von Diamant mit Stickstoffatomen umfaßt, um eine Stickstoffatomkonzentration von $1 \times 10^{19}$ cm$^{-3}$ oder mehr vorzusehen, und zwar durch Verwendung eines ein stickstoffatomenthaltendes Gas umfassenden Reaktionsgases.

**6.** Halbleiterdiamant nach Anspruch 1, welcher eine Halbwertsbreite einer Rocking-Kurve von 40 Sekunden oder weniger aufweist und zwar auf der Grundlage eines Doppelkristall-Röntgenbeugungsverfahrens.

## Revendications

**1.** Diamant semi-conducteur comprenant du diamant dopé avec des atomes d'azote et des atomes de bore, respectivement en une concentration d'atomes d'azote (CN) et une concentration d'atomes de bore (CB) satisfaisant à la relation de $100CB \geq CN > CB$, et ayant une concentration de porteurs de $1 \times 10^{16}$/cm$^{-3}$ ou plus.

**2.** Diamant semi-conducteur selon la revendication 1, qui comprend du diamant dopé avec des atomes d'azote en une concentration de $1 \times 10^{19}$/cm$^{-3}$ ou plus.

**3.** Diamant semi-conducteur selon la revendication 1, qui comprend du diamant dopé avec des atomes d'azote en une concentration de $1 \times 10^{19}$/cm$^{-3}$ ou plus, et ayant une profondeur de demi-exposition de la courbe d'oscillation de 40 secondes ou moins sur la base d'un procédé de diffraction des rayons X à double cristal.

**4.** Procédé pour fabriquer un diamant semi-conducteur par dépôt de vapeur, comprenant le dopage de diamant avec des atomes d'azote et des atomes de bore de façon à fournir une concentration d'atomes d'azote (CN) et une concentration d'atomes de bore (CB) satisfaisant à la relation $100CB \geq CN > CB$, et ayant une concentration de porteurs de $1 \times 10^{16}$/cm$^{-3}$ ou plus, en utilisant un gaz réactif comprenant un gaz contenant des atomes d'azote et un gaz contenant des atomes de bore de façon à fournir une concentration d'atomes d'azote prédéterminée.

**5.** Procédé pour fabriquer un diamant semi-conducteur selon la revendication 3, qui comprend le dopage de diamant avec des atomes d'azote de façon à fournir une concentration d'atomes d'azote de $1 \times 10^{19}$/cm$^{-3}$ ou plus, en utilisant un gaz réactif comprenant un gaz contenant des atomes d'azote.

**6.** Diamant semi-conducteur selon la revendication 1, qui a une profondeur de demi-exposition de la courbe d'oscillation de 40 secondes ou moins sur la base d'un procédé de diffraction des rayons X à double cristal.

Fig. 1

Fig.2